(19) Europäisches Patentamt

European Patent Office

Office européen des brevets

(11) Veröffentlichungsnummer: **0 150 445**

**B1**

(12) **EUROPÄISCHE PATENTSCHRIFT**

(45) Veröffentlichungstag der Patentschrift: **14.03.90**

(21) Anmeldenummer: **84115822.3**

(22) Anmeldetag: **19.12.84**

(51) Int. Cl.⁵: **G 03 F 9/00**

(54) **Einrichtung zur passgenauen Filmmontage für die Herstellung von Druckplatten für Kleinoffsetmaschinen.**

(30) Priorität: **26.01.84 DE 8402101 u**

(43) Veröffentlichungstag der Anmeldung:
**07.08.85 Patentblatt 85/32**

(45) Bekanntmachung des Hinweises auf die
Patenterteilung:
**14.03.90 Patentblatt 90/11**.

(84) Benannte Vertragsstaaten:
**AT BE CH FR GB IT LI NL SE**

(56) Entgegenhaltungen:

**Keine Entgegenhaltungen.**

(73) Patentinhaber: **Heidelberger Druckmaschinen
Aktiengesellschaft
Kurfürsten-Anlage 52-60 Postfach 10 29 40
D-6900 Heidelberg 1 (DE)**

(72) Erfinder: **D'Heureuse, Walter
Im oberen Rech 37
D-6802 Ladenburg (DE)**
Erfinder: **Demmerle, Rolf
Burgweg 28
D-6905 Schriesheim (DE)**

(74) Vertreter: **Stoltenberg, Baldo Heinz-Herbert
c/o Heidelberger Druckmaschinen AG
Kurfürsten-Anlage 52-60
D-6900 Heidelberg 1 (DE)**

## Beschreibung

Die Neuerung betrifft eine Einrichtung zur paßgenauen Filmmontage für die Herstellung von Druckplatten für Kleinoffsetmaschinen unter Verwendung von als Vorlage dienenden Standbogen und der Filmmontage dienenden Montagefolien.

Bei den weltweit zum Einsatz kommenden Kleinoffsetmaschinen werden üblicherweise bereits vorgelochte Metall-, Kunststoff- oder Papierdruckfolien eingesetzt. Diese "Druckplatten" werden in den Zylinderkanal des Plattenzylinders der Maschine eingezogen, wobei sie am Plattenanfang und Ende in der Regel auf eine Hakenleiste aufgespannt sind, so daß sie gut auf der Zylinderoberfläche aufliegen. Die genannte Hakenleiste weist dabei Greiferfinger auf, die in regelmäßigen Abständen nebeneinander angeordnet sind und in entsprechende Lochreihen der Druckplatte eingreifen. Dabei gibt es hinsichtlich Form und Anordnung dieser Lochreihen unterschiedliche Systeme. Die gebräuchlichsten sind dabei:

1. Rundloch $\phi$ 4,5 mm mit 12,5 mm Lochabstand,

2. Rundloch $\phi$ 4,0 mm mit 12,7 mm Lochabstand "Pinbar" genannt und

3. Langloch 5,5 mm x 11,0 mm mit 29,67 mm Lochabstand, "Hookbar" genannt.

Die Anbieter von Kleinoffsetdruckmaschinen der Formatklasse bis etwa DIN A3 haben sich jeweils weitestgehend auf eine dieser Perforationen festgelegt. Nur auf ausdrücklichen Wunsch der Kunden wird auch die Hakenleiste für die jeweils andere Registerlochung in die Maschine eingebaut. In vielen Fällen ist dabei ein Spezialplattenzylinder erforderlich.

Zur Herstellung der Druckplatte selbst wird häufig ein mit den Registerlochungen eines der obengenannten Systeme ausgestatteter Standbogen als Vorlage verwendet, auf dem die zu druckenden Filme standgerecht angeordnet sind. Auf diesen Standbogen wird eine ebenfalls mit diesen Registerlochungen versehene Montagefolie für die Herstellung der Druckplatte paßgenau gelegt, auf welcher dann die einzelnen Filme gemäß der Vorlage des unter ihr sich abzeichnenden Standbogens montiert werden.

Die Druckmaschine beinhaltet zwar alle Einrichtungen, um ein auf der Druckform ungenau angeordnetes Druckbild im Umfang- und Seitenregister zu korrigieren, es ist jedoch von großem Vorteil (Zeitersparnis bei der Einrichtung der Maschine, wenig Makulatur), wenn das Druckbild auf der Druckplatte paßgenau angeordnet ist.

Davon ausgehend besteht die Aufgabe der vorliegenden Neuerung nun darin, ein Hilfsmittel zu schaffen, mit dem unter Berücksichtigung der gegebenen Systemvielfalt von Registerlochungen im Kleinoffsetbereich eine paßgenaue Montage des Druckbildes auf der Druckform über Standbogen und Montagefolie ermöglicht werden kann.

Die gestellte Aufgabe wird neuerungsgemäß durch eine Einrichtung gemäß Anspruch 1 gelöst.

Eine Ausführungsform ist in den Zeichnungen dargestellt. Dabei zeigt:

Fig. 1 die Filmmontage mittels der neuerungsgemäßen Schablone,

Fig. 2 eine Ausführungsform der Schablone,

Fig. 3 eine Seitenansicht derselben und

Fig. 4 eine Ausschnittsvergrößerung nach Fig. 3.

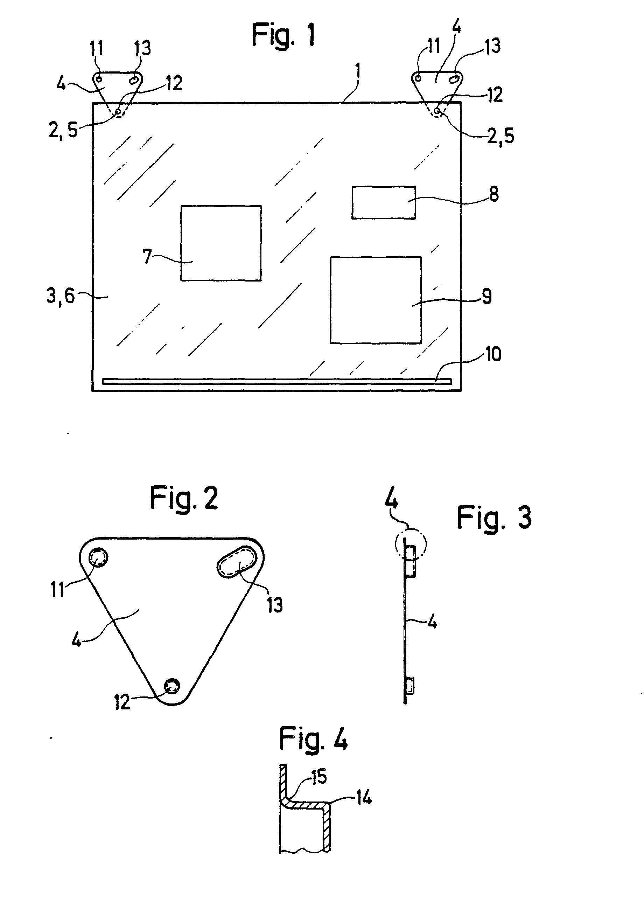

Wie Figur 1 zeigt, sind jeweils an der linken und rechten Seite der Vorderkante 1 eines mit den Registerlochungen 2 versehenen Standbogens 3 eine neuerungsgemäße, als flaches Plättchen ausgebildete Schablone 4 vorgesehen, wobei der Standbogen 3 mit seinen gestanzten Registerlochungen 2 in entsprechende Nocken 11 der Schablone 4 eingehängt ist. Deckungsgleich und aufgrund entsprechender Registerlochungen 5 paßgenau ist auf den Standbogen 3 eine Montagefolie 6 gelegt und ebenfalls in die Nocken 11 eingehängt, so daß sie dann mit den zu druckenden Filmen 7, 8, 9 und 10 gemäß der Vorlage des unter der Montagefolie 6 sich abzeichnenden Standbogens 3 versehen werden kann, um danach mit der zu belichtenden Offsetdruckplatte in Kontakt gebracht zu werden, so daß eine registerhaltige standgenaue Plattenkopie ermöglicht wird.

Figur 2 zeigt die vergrößerte Darstellung einer Schablone 4, welche im Ausführungsbeispiel vorzugsweise als gleichseitiges Dreieck ausgeführt ist, und die drei hauptsächlich gebräuchlichen Systeme von Registerlochungen insofern berücksichtigt, als die passenden Nocken 11, 12, 13 zu Rundloch $\phi$ 4,5 mm, Rundloch $\phi$ 4,0mm (Pinbar) und Langloch 5,5 mm x 11,0 mm (Hookbar) gleichmäßig verteilt jeweils im Bereich einer Ecke aufgebracht sind. Die Schablone 4 selbst kann dabei vorzugsweise aus metallischem Werkstoff oder Kunststoff bestehen und sollte formstabil sein.

Die in Figur 4 der Vollständigkeit halber dargestellte Ausschnittsvergrößerung der Seitenansicht gemäß Figur 3 verdeutlicht die an entsprechenden Stellen (Kanten) mit Rundungen 14, 15 versehene Nockenform, um dadurch das Einpassen von Standbogen 3 und Montagefolie 6 zu erleichtern und deren Registerlochungen nicht zu beschädigen.

## Patentansprüche

1. Einrichtung zur paßgenauen Filmmontage für die Herstellung von Druckplatten für Kleinoffsetmaschinen unter Verwendung von als Vorlage dienenden Standbogen und der Filmmontage dienenden Montagefolien, dadurch gekennzeichnet, daß eine universell verwendbare Schablone (4) vorgesehen ist, die eine Anzahl von unterschiedlichen, den auf dem Markt gebräuchlichen Registerlochungs-Systemen entsprechenden Nocken (11, 12, 13) zum übereinanderliegenden Einhängen von Standbogen (3) und Montagefolie (6) aufweist, wobei Standbogen (3) und Montagefolie (6) mit den Registerlochungen mindestens eines dieser Systeme versehen sind.

2. Einrichtung nach Anspruch 1, dadurch gekennzeichnet, daß den Registerlochungen (2, 5) der linken und rechten Seite der Vorderkante (1) von Standbogen (3) und Montagefolie (6) jeweils

eine Schablone (4) zugeordnet ist.

3. Einrichtung nach Anspruch 1 oder 2, dadurch gekennzeichnet, daß die Schablone (4) die Nocken (11, 12, 13) zu den Registerlochungen Rundloch ⌀ 4,5 mm, Rundloch ⌀ 4,0 mm (Pinbar) und Langloch 5,5 mm x 11,0 mm (Hookbar) aufweist.

4. Einrichtung nach einem oder mehreren der Ansprüche 1-3, dadurch gekennzeichnet, daß die Schablone (4) aus formstabilem metallischem Werkstoff oder Kunststoff besteht und die Nocken (11, 12, 13) zum erleichterten Einpassen von Standbogen (3) und Montagefolie (6) mit gerundeten Kanten (14, 15) versehen sind.

5. Einrichtung nach einem oder mehreren der Ansprüche 1-3, dadurch gekennzeichnet, daß die Schablone (4) vorzugsweise als flaches Plättchen in Form eines gleichseitigen Dreieckes ausgebildet ist, und die Registernocken (11, 12, 13) gleichmäßig verteilt jeweils im Bereich einer Ecke aufgebracht sind.

## Revendications

1. Dispositif pour monter un film avec précision pour la fabrication de plaques d'impression pour des petites machines offset, en employant une feuille support qui sert de modèle et des feuilles de montage qui servent à monter le film, caractérisé en ce qu'il est prévu un gabarit (4) d'emploi universel qui présente un certain nombre de bossages (11, 12, 13), différents et correspondant aux systèmes de perforation de registre courants sur le marché pour accrocher, l'une au-dessus de l'autre, une feuille support (3) et une feuille de montage (6) étant précisé que la feuille support (3) et la feuille de montage (6) sont munies des perforations de registre d'au moins l'un de ces systèmes.

2. Dispositif selon la revendication 1, caractérisé en ce qu'aux perforations de registre (2,5) du côté gauche et du côté droit du bord avant (1) de la feuille support (3) et de la feuille de montage (6), correspond chaque fois un gabarit (4).

3. Dispositif selon la revendication 1 ou 2, caractérisé en ce que le gabarit (4) présente les bossages (11, 12, 13) correspondant aux perforations de registre trou rond ⌀ 4,5 mm, trou rond ⌀ 4,0 mm (Pinbar) et trou allongé 5,5 mm x 11,0 mm (Hookbar).

4. Dispositif selon une ou plusieurs des revendications 1-3, caractérisé en ce que le gabarit (4) est constitué d'un matériau métallique ou plastique de forme stable, et en ce que, pour faciliter la mise en place de la feuille support (3) et de la feuille de montage (6), les bossages (11, 12, 13) sont munis d'arêtes arrondies (14, 15).

5. Dispositif selon une ou plusieurs des revendications 1-3, caractérisé en ce que le gabarit (4) est de préférence réalisé en une plaquette plane ayant la forme d'un triangle équilatéral, et en ce que les bossages de registre (11, 12, 13) y sont rapportés, en étant régulièrement répartis, chacun dans la zone d'un angle.

## Claims

1. Device for in-register film mounting for the production of printing plates for small offset printing machines using register sheets serving as originals and mounting foils serving for film mounting characterized in that there is provided a universally usable template (4) having a plurality of differently shaped pins (11, 12, 13) corresponding to conventionally used register-hole systems for suspending superimposed register sheet (3) and mounting foil (6), register sheet (3) and mounting foil (6) each being provided with register holes of at least one of said systems.

2. Device according to Claim 1, characterized in that a respective template (4) is assigned to the register holes (2, 5) of the left-hand side and the right-hand side of the leading edge (1) of register sheet (3) and mounting foil (6).

3. Device according to Claim 1 or 2, characterized in that the template (4) features the pins (11, 12, 13) for the register holes including a round hole having a diameter of 4.5mm, a round hole having a diameter of 4.0mm (pin bar) and an oblong hole having a width of 5.5mm and a length of 11.0mm (hook bar).

4. Device according to one or several of the Claims 1 through 3, characterized in that the template (4) consists of dimensionally stable metallic material or plastic material and that the pins (11, 12, 13) have rounded edges (14, 15) for facilitating the accommodation of register sheet (3) and mounting foil (6).

5. Device according to one or several of the Claims 1 through 3, characterized in that the template (4) is preferably designed as a flat plate in the form of an equilateral triangle and that the register pins (11, 12, 13) are distributed uniformly in the respective areas of the corners of said triangle.

# Fig. 1

# Fig. 2

# Fig. 3

# Fig. 4